# EUROPEAN PATENT APPLICATION

(11) **EP 2 001 058 A1**
(43) Date of publication of application: **10.12.2008**
(21) Application number: 07011261.0
(22) Date of filing: 08.06.2007
(51) Int. Cl.: H01L 33/00

(54) **Solder-type light-emitting diode chip assembly and method of bonding a solder-type light-emitting diode chip**

(71) Applicant: Augux Co., Ltd., Hueishan Township Taoyuan County 333 (TW)
(72) Inventor: Wang, Pei-Choa, Gueishan Township TAOYUAN COUNTY 333 (TW)
(74) Representative: Urner, Peter

(57) **Abstract**

The invention relates to a soldering type light emitting diode chip assembly comprising: a conductive layer (3); a solder paste (4) coated on the conductive layer (3) and a light emitting diode chip (5) placed on the solder paste (4). Further, it relates to a method of bonding a low-resistance solder type light emitting diode chip, wherein a copper substrate (1) is prepared; an insulating layer (2) is coated on the copper substrate (1); a conductive layer (3) is formed on the insulating layer (2); a solder paste (4) is coated onto the conductive layer by silk screen printing; and the chip (5) is placed on the conductive layer (3) and heated to melt the solder paste (4) coated between the conductive layer and the chip; and finally the copper substrate (1) is cooled such that the solder paste (4) forms a solder layer to mount the chip onto the conductive layer.

## Description

### BACKGROUND OF THE INVENTION

### 1. Field of the Invention

The present invention relates to a light emitting diode (LED), and more particular to a method of bonding a light emitting diode chip.

### 2. Description of Prior Art

Light emitting diode comes with the advantages of a compact size, a long life expectancy, a low power consumption, a quick response rate, and a shockproof feature, and thus it is widely used as a light emitting component for various different electric appliances, information billboards, and communication products.

At present, there are different types of light emitting diodes, which can be divided into high-brightness light emitting diodes and moderate-brightness emitting diodes according to the level of brightness. High-brightness light emitting diodes are light emitting diodes made of quaternary compounds and GaN series compounds and moderate-brightness light emitting diodes are light emitting diodes made of binary compounds and ternary compounds other than the GaN series compounds. Since high-brightness light emitting diodes produce tremendous heat energy during their operations, therefore it is necessary to install a heat sink on the circuit substrate of each high-brightness light emitting diode or a heat slug on the lead frame, so that a heat dissipating mechanism can conduct the heat energy produced by the high-brightness light emitting diode chip to the heat sink or heat slug for the heat dissipation to extend the life expectancy of the high-brightness light emitting diodes.

However, traditional high-brightness light emitting diodes generally come with a low heat conductivity, since a silver paste is used for bonding a chip onto a conductive layer or a lead frame of the substrate when the high-brightness light emitting diode is bonded, and the thermal resistance of the silver paste is relatively high. As a result, it is difficult to control the thickness of the silver paste coated onto the conductive layer or the lead frame by a dispersion method and thus adversely affecting the conduction of the heat produced by the chip.

### SUMMARY OF THE INVENTION

In view of the foregoing shortcomings of the prior art, the inventor of the present invention based on years of experience in the related industry to conduct experiments and modifications, and finally invented a soldering type light emitting diode chip assembly and a method of bonding a light emitting diode chip in accordance with the present invention.

Therefore, it is a primary objective of the present invention to provide a soldering type light emitting diode chip assembly and a method of die bonding a solder type light emitting diode by using a solder with a low thermal resistance and controlling the solder thickness in a range of 4~5µm to enhance the effect of heat conduction.

To achieve the foregoing objective, the present invention provides a soldering type light emitting diode chip assembly, comprising: a conductive layer; a solder paste coated on the conductive layer; and a light emitting diode chip placed on the solder paste. By using a solder paste coated on the conductive layer it is possible to achieve low thermal resistance and to thereby reduce the generation of heat.

In a further preferred embodiment the soldering type light emitting diode chip assembly includes further: a copper substrate and an insulating layer formed on the surface of the copper substrate, wherein the conductive layer having the solder paste coated on the conductive layer and the light emitting diode chip placed on the solder paste are formed on the insulating layer. By using the copper substrate and an insulating layer a heat sink is provided facilitating the removing of generated heat to thereby increase the life time of the light emitting diode. Moreover, by using the copper substrate below the insulation layer and the conductive layer having the light emitting diode chip placed thereon it is possible to control the thickness of the solder paste. By having a solder paste having a reduced thickness the resistance of the solder paste is reduced and thereby the generation of heat is reduced.

In a preferred embodiment the thickness of the solder paste is about 4-5µm.

The object is further achieved by a method of die bonding a solder type light emitting diode, the method comprises the steps of: coating a solder paste on a conductive layer; placing the light emitting diode chip on the solder paste; heating and melting the solder paste and cooling the solder paste. By placing the solder paste on a conductive layer and then placing the light emitting diode chip on the solder paste the thermal resistance is reduced compared with a assemble using silver. Moreover, by using a controlled heating and melting process the thickness of the solder paste may be adjusted to thereby achieve a reduced thickness of the solder paste to finally achieve a reduced heat generation. Even better results in respect to the thickness of the solder paste are achieved using a controlled cooling process after the heating and melting step. This active cooling step provides a tool for exactly defining the thickness of the solder paste.

In a preferred embodiment the method for includes the steps of: preparing a copper substrate; forming an insulating layer on a surface of the copper substrate; forming a conductive layer on the insulating layer; coating the solder paste onto the conductive layer; placing the chip on the conductive layer; heating and melting the solder paste coated between the conductive layer and the chip, and finally cooling the copper substrate, such that the solder paste forms a thin film solder layer for bonding the chip on the conductive layer.

In a further preferred embodiment the coating of the solder paste onto the conductive layer is achieved by using a silk screen printing to thereby easily controlling the amount of solder paste coated on the conductive layer. Moreover, by using a thermal insulating material for the insulation layer the cooling process could be improved.

### BRIEF DESCRIPTION OF DRAWINGS

The features of the invention believed to be novel are set forth with particularity in the appended claims. The invention itself however may be best understood by reference to the following detailed description of the invention, which describes certain exemplary embodiments of the invention, taken in conjunction with the accompanying drawings in which:
Fig. 1 is a flow chart of die boding a light emitting diode in accordance with the present invention;
Fig. 2 is a schematic view of an insulating layer formed on a copper substrate in accordance with the present invention;
Fig. 3 is a schematic view of a conductive layer formed on an insulating layer in accordance with the present invention;
Fig. 4 is a schematic view of a solder paste applied on a conductive layer in accordance with the present invention;
Fig. 5 is a schematic view of a soldering type light emitting diode chip assembly in accordance with the present invention; and
Fig. 6 is a side view of a substrate of the present invention.

### DETAILED DESCRIPTION OF THE INVENTION

The technical characteristics, features and advantages of the present invention will become apparent in the following detailed description of the preferred embodiments with reference to the accompanying drawings. The drawings are provided for reference and illustration only, but not intended for limiting the present invention.

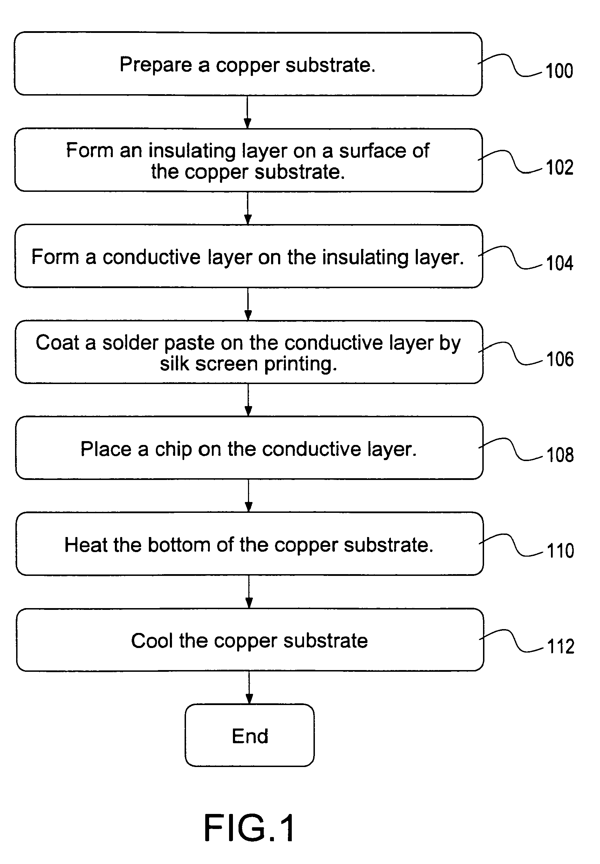

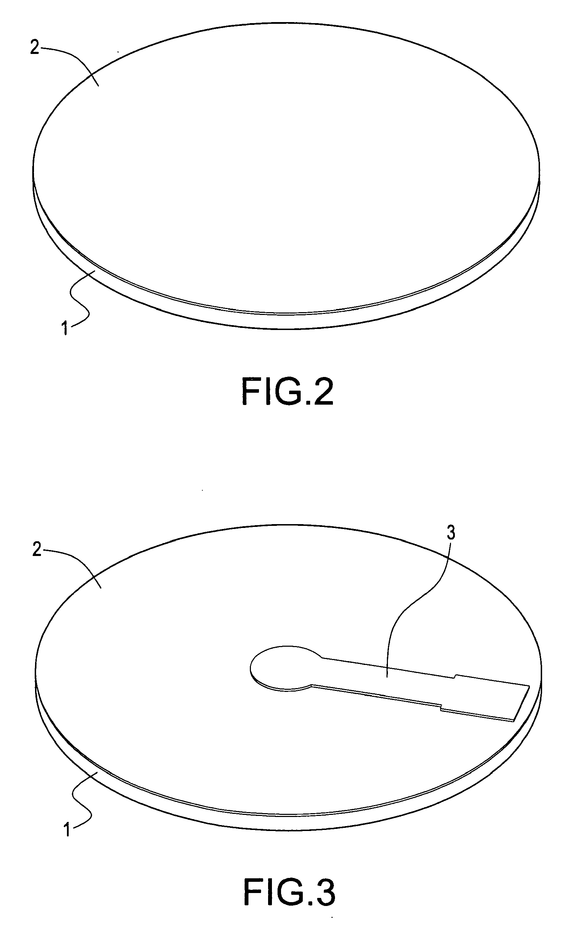

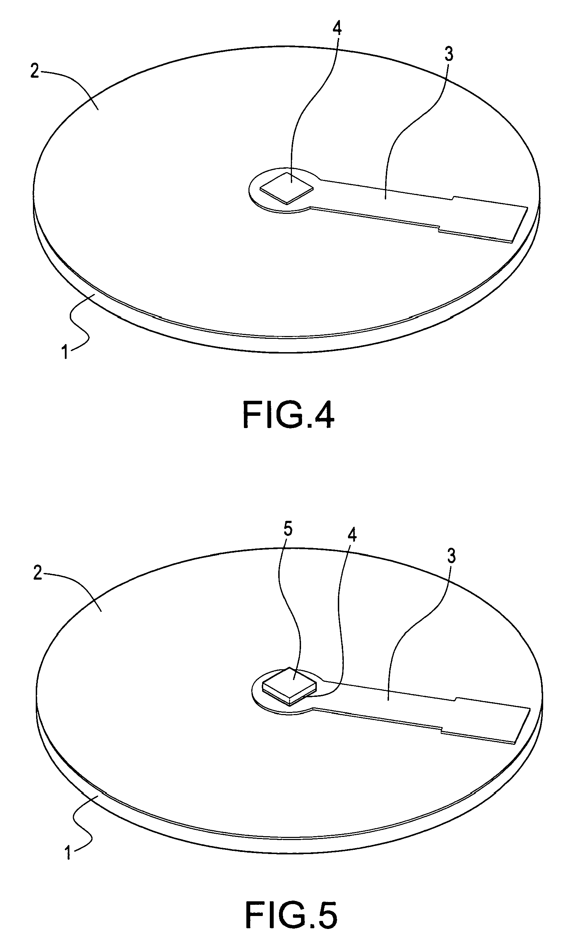

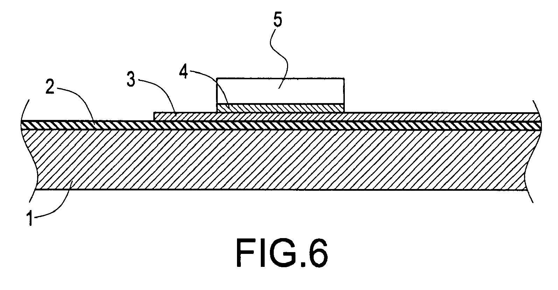

Referring to Fig. 1 for a flow chart of die bonding a light emitting diode in accordance with the present invention, and a method of die bonding a solder type light emitting diode comprises the following steps:
In Step 100, a copper substrate 1 as shown in Fig. 2 is prepared.
In Step 102, an insulating layer 2 is formed on a surface of the copper substrate 1. In the figure, the insulating layer is made of a thermal insulating material.
In Step 104, a conductive layer 3 is formed on the insulating layer as shown in Fig. 3.
In Step 106, a solder paste 4 is coated at a predetermined bonding position on the conductive layer 3 by silk screen printing as shown in Fig. 4.
In Step 108, a light emitting diode chip 5 is placed on the conductive layer 3 as shown in Fig. 5.
In Step 110, the bottom of the copper substrate 1 is heated to melt the solder paste 4 coated between the conductive layer 3 and the chip 5.
In Step 112, the copper substrate 1 is cooled, so that the solder paste 4 forms a thin film solder layer to bond the chip 5 on the conductive layer 3 as shown in Fig. 6.

During the foregoing fabrication process, the quantity of solder paste coated onto the conductive layer 3 can be controlled by the mesh size of a silk screen. However, other suited method for coating a determined amount of solder paste onto the conductive layer 3 could be used, also. After the heating and cooling processes, the solder layer bonds the chip 5 on the conductive layer 3, and the thickness of the solder layer can be controlled in a range of 4~5µm. In addition, the thermal resistance of the solder paste 4 is smaller than that of a conventional silver paste, and thus the heat produced by the chip 5 can be conducted rapidly to the copper substrate 1 for the heat dissipation. The use of the copper substrate and the insulation layer could be omitted also to achieve the first reduction of thermal resistance by using a solder paste instead of a silver paste. However, to further reduce the thickness of the solder paste to thereby further reduce the generation of heat by the solder paste the copper substrate and the insulation layer are useful for the controlled heating, melting and cooling process.

The present invention is illustrated with reference to the preferred embodiments and not intended to limit the patent scope of the present invention. Various substitutions and modifications have suggested in the foregoing description, and other will occur to those of ordinary skill in the art. Therefore, all such substitutions and modifications are intended to be embraced within the scope of the invention as defined in the appended claims.

## Claims

1. Soldering type light emitting diode chip assembly, comprising:
a conductive layer (3);
a solder paste (4) coated on the conductive layer (3);
a light emitting diode chip (5) placed on the solder paste (4).

2. Soldering type light emitting diode chip assembly as claimed in claim 1, further comprising:
a copper substrate (1);
an insulating layer (2) formed on the surface of the copper substrate (1); wherein the conductive layer (3) having the solder paste (4) coated on the conductive layer (3) and the light emitting diode chip (5) placed on the solder paste (4) is formed on the insulating layer (2).

3. Soldering type light emitting diode chip assembly as claimed in claim 1,wherein the solder paste (4) has a thickness of4-5µm.

4. Method for bonding a light emitting diode chip, comprising the steps of:
coating (S106) a solder paste (4) on a conductive layer (3);
placing (S108) the light emitting diode chip (5) on the solder paste (4);
heating (S110) and melting the solder paste (4); and
cooling (S112) the solder paste (4).

5. Method of claim 4, further comprising prior the coating step:
preparing (S100) a copper substrate (1);
forming (S102) an insulating layer (2) on the surface of the copper substrate (1); and
forming (S104) a conductive layer (3) on the insulating layer (2);

6. Method of claim 4 or 5, wherein the coating is performed by a silk screen printing.

7. Method of claim 5, wherein the insulating layer (2) is made of a thermal insulating material.

8. Method according to one of the claims 4-7, wherein the solder paste (4) has a thickness of 4-5µm.
